(19) Europäisches Patentamt
European Patent Office
Office européen des brevets

(11) EP 4 542 306 A1

(12) **EUROPEAN PATENT APPLICATION**
published in accordance with Art. 153(4) EPC

(43) Date of publication:
**23.04.2025 Bulletin 2025/17**

(21) Application number: **23827064.9**

(22) Date of filing: **14.06.2023**

(51) International Patent Classification (IPC):
***G03F 7/32*** (2006.01) ***G03F 7/004*** (2006.01)
***G03F 7/20*** (2006.01) ***H01L 21/027*** (2006.01)

(52) Cooperative Patent Classification (CPC):
**G03F 7/004; G03F 7/20; G03F 7/32; H01L 21/027**

(86) International application number:
**PCT/JP2023/021998**

(87) International publication number:
**WO 2023/248878 (28.12.2023 Gazette 2023/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **20.06.2022 JP 2022098788**
**27.03.2023 JP 2023049522**

(71) Applicant: **FUJIFILM Corporation**
**Tokyo 106-8620 (JP)**

(72) Inventor: **SHIRAKAWA Michihiro**
**Haibara-gun, Shizuoka 421-0396 (JP)**

(74) Representative: **HGF**
**HGF Limited**
**1 City Walk**
**Leeds LS11 9DX (GB)**

(54) **PATTERN FORMING METHOD AND METHOD FOR PRODUCING ELECTRONIC DEVICE**

(57) An object of the present invention is to provide a pattern forming method capable of forming a pattern having excellent limit resolution, and a method for manufacturing an electronic device. The pattern forming method of the present invention is a pattern forming method having a step 1 of forming a metal resist film on a substrate using an actinic ray-sensitive or radiation-sensitive resin composition including a metal compound having at least one bond selected from the group consisting of a metal-carbon bond and a metal-oxygen bond, a step 2 of exposing the metal resist film, and a step 3 of obtaining a pattern by subjecting the exposed metal resist film to a development treatment with a developer including an organic solvent to remove a non-exposed portion, in which the pattern forming method may further have, after the step 3, a step 4 of washing the pattern with a rinsing liquid including an organic solvent, and the developer or the rinsing liquid satisfies predetermined requirements.

EP 4 542 306 A1

## Description

## BACKGROUND OF THE INVENTION

1. Field of the Invention

The present invention relates to a pattern forming method and a method for manufacturing an electronic device.

2. Description of the Related Art

Since the advent of a resist for a KrF excimer laser (wavelength: 248 nm), a pattern forming method utilizing chemical amplification has been used to compensate for a decrease in sensitivity due to light absorption.

In order to miniaturize semiconductor elements, wavelengths of exposure light sources have been shortened and numerical apertures (NAs) of projection lenses have been increased, and currently, exposure devices using an ArF excimer laser having a wavelength of 193 nm as a light source have been developed. In addition, in recent years, pattern forming methods using extreme ultraviolet rays (extreme ultraviolet (EUV) light) or an electron beam (EB) as a light source are also being studied.

Under such circumstances, a pattern forming method using an actinic ray-sensitive or radiation-sensitive resin composition including a metal compound has been proposed.

US2020/0326627A discloses a method for forming a pattern by exposing a coating layer formed using a resist material including a metal compound and then performing development with a specific developer.

## SUMMARY OF THE INVENTION

As a result of studying the pattern forming method described in US2020/0326627A, the present inventors have found that, in a case of forming a fine pattern, the pattern may be likely to collapse or it may be difficult to form a fine pattern in the first place. Hereinafter, when a pattern obtained is less likely to collapse and is fine, such a pattern is also referred to as a pattern with excellent limit resolution.

Therefore, an object of the present invention is to provide a pattern forming method capable of forming a pattern with excellent limit resolution.

Another object of the present invention is to provide a method for manufacturing an electronic device using the pattern forming method.

As a result of intensive studies to solve the above-described problems, the present inventors have found that the above-described problems can be solved by the following configurations.

(1) A pattern forming method having a step 1 of forming a metal resist film on a substrate using an actinic ray-sensitive or radiation-sensitive resin composition including a metal compound having at least one bond selected from the group consisting of a metal-carbon bond and a metal-oxygen bond; a step 2 of exposing the metal resist film; and a step 3 of obtaining a pattern by subjecting the exposed metal resist film to a development treatment with a developer including an organic solvent to remove a non-exposed portion, wherein the pattern forming method may further have, after the step 3, a step 4 of washing the pattern with a rinsing liquid including an organic solvent, in a case where the pattern forming method does not have the step 4 after the step 3, the developer is a chemical liquid including two or more kinds of organic solvents, in a case where the pattern forming method comprises the step 4 after the step 3, at least one of the developer or the rinsing liquid is a chemical liquid including two or more kinds of organic solvents, and the chemical liquid including two or more kinds of organic solvents includes at least an organic solvent in which a sum of a polar term $\delta_P$ and a hydrogen-bonding term $\delta_H$ in Hansen solubility parameters is less than 9.8 $(J/cm^3)^{0.5}$.

(2) The pattern forming method according to (1), in which the chemical liquid including two or more kinds of organic solvents includes at least an organic solvent in which a sum of a polar term $\delta_P$ and a hydrogen-bonding term $\delta_H$ in Hansen solubility parameters is less than 8.0 $(J/cm^3)^{0.5}$.

(3) The pattern forming method according to (1) or (2), in which the chemical liquid including two or more kinds of organic solvents includes an organic solvent A and an organic solvent B, a boiling point of the organic solvent A is higher than a boiling point of the organic solvent B, and a sum of a polar term $\delta_P$ and a hydrogen-bonding term $\delta_H$ in Hansen solubility parameters of the organic solvent A is smaller than a sum of a polar term $\delta_P$ and a hydrogen-bonding term $\delta_H$ in Hansen solubility parameters of the organic solvent B.

(4) The pattern forming method according to any one of (1) to (3), in which the metal compound includes at least one selected from the group consisting of a compound represented by Formula (1) described later, a compound represented by Formula (2) described later, and a condensate of the compound represented by Formula (2).

(5) The pattern forming method according to any one of (1) to (4), in which a content of the metal compound is 50% by

mass or more with respect to a total solid content of the composition.
(6) A method for manufacturing an electronic device, the method including the pattern forming method according to any one of (1) to (5).

According to the present invention, it is possible to provide a pattern forming method capable of forming a pattern having excellent limit resolution.
In addition, according to the present invention, it is possible to provide a method for manufacturing an electronic device using the pattern forming method.

## DESCRIPTION OF THE PREFERRED EMBODIMENTS

Hereinafter, the present invention will be described in detail.
Although the following constituent elements may be described in detail based on representative embodiments of the present invention, the present invention is not limited to such embodiments.
Unless otherwise specified, a substituent is preferably a monovalent substituent.
The "actinic ray" or "radiation" in the present specification means, for example, an emission line spectrum of a mercury lamp, far ultraviolet rays typified by an excimer laser, extreme ultraviolet rays (extreme ultraviolet (EUV) light), X-rays, electron beams (EB), or the like. The term "light" in the present specification means actinic ray or radiation.
The "exposure" in the present specification includes not only the exposure with an emission line spectrum of a mercury lamp, far ultraviolet rays typified by an excimer laser, extreme ultraviolet rays, X-rays, EUV light, or the like, but also drawing with a particle beam such as an electron beam or an ion beam, unless otherwise specified.
In the present specification, a range of numerical values expressed with "to" mean a range that includes a numerical value before "to" as a lower limit and a numerical value after "to" as an upper limit.
A bonding direction of a divalent group expressed in the present specification is not limited unless otherwise specified. For example, in a case where Y in a compound represented by a formula "X-Y-Z" is -COO-, Y may be -CO-O- or -O-CO-. In addition, the compound may be "X-CO-O-Z" or "X-O-CO-Z".
In the present specification, examples of a halogen atom include a fluorine atom, a chlorine atom, a bromine atom, and an iodine atom.
In the present specification, a solid component means a component which forms a metal resist film, and does not include solvents (for example, an organic solvent and water). In **addition,** even in a case where a component is in a liquid state, the component is regarded as a solid component as long as the component forms a metal resist film.
**In** the present specification, a boiling point is a value at 1 atm (760 mmHg) and means a normal boiling point.

[Pattern Forming Method]

The pattern forming method according to the present invention is a pattern forming method having a step 1 of forming a metal resist film on a substrate using an actinic ray-sensitive or radiation-sensitive resin composition (hereinafter, also referred to as "metal resist composition") including a metal compound having at least one bond selected from the group consisting of a metal-carbon bond and a metal-oxygen bond (hereinafter, such a metal compound is also referred to as "specific metal compound"); a step 2 of exposing the metal resist film; and a step 3 of obtaining a pattern by subjecting the exposed metal resist film to a development treatment with a developer including an organic solvent to remove a non-exposed portion, in which the pattern forming method may further have, after the step 3, a step 4 of washing the pattern with a rinsing liquid including an organic solvent, in a case where the pattern forming method does not have the step 4 after the step 3, the developer is a chemical liquid including two or more kinds of organic solvents, in a case where the pattern forming method has the step 4 after the step 3, at least one of the developer or the rinsing liquid is a chemical liquid including two or more kinds of organic solvents, and the chemical liquid including two or more kinds of organic solvents includes at least an organic solvent in which a sum of a polar term $\delta_P$ and a hydrogen-bonding term $\delta_H$ (hereinafter, also referred to as "$\delta_P + \delta_H$") in Hansen solubility parameters is less than 9.8 $(J/cm^3)^{0.5}$.
Hereinafter, a chemical liquid including two or more kinds of organic solvents, the chemical liquid including at least an organic solvent having a $\delta_P + \delta_H$ in Hansen solubility parameters of less than 9.8 $(J/cm^3)^{0.5}$ (in other words, a chemical liquid including two or more kinds of organic solvents, in which at least one of the organic solvents included in the chemical liquid is an organic solvent having a $\delta_P + \delta_H$ in Hansen solubility parameters of less than 9.8 $(J/cm^3)^{0.5}$) is also referred to as "specific chemical liquid".
The mechanism of action by which the desired effect is obtained in the above-described pattern forming method is not necessarily clear, but the present inventors have presumed as follows.
The features of the pattern forming method according to the present invention include the point that the metal resist composition including the specific metal compound is used, and the point that the specific chemical liquid is used in at least one of the developer in the step 3 or the rinsing liquid in the step 4.

In a case where the metal resist film is subjected to the exposure treatment in the step 2, at least one bond selected from the group consisting of a metal-carbon bond and a metal-oxygen bond of the specific metal compound is cleaved in the exposed portion, and the specific metal compounds is polymerized (crosslinked) from the cleaved portion as a starting point, so that a difference in solubility (dissolution contrast) in an organic solvent is exhibited between the exposed portion and the non-exposed portion. In a case where the specific chemical liquid is applied to at least one of the developer in the step 3 or the rinsing liquid in the step 4, since the specific chemical liquid includes a plurality of organic solvents, it is presumed that, as compared with the polymer derived from the specific metal compound generated by the exposure treatment, the specific chemical liquid easily forms a solvate with the specific metal compound before the exposure, and as a result, the effect of obtaining excellent dissolution contrast between the exposed portion and the non-exposed portion is obtained. In addition, since the specific chemical liquid includes at least the organic solvent having a $\delta_P + \delta_H$ of less than 9.8 $(J/cm^3)^{0.5}$, it is presumed that the permeation of the specific chemical liquid into the exposed portion can be suppressed in the step 3 and the step 4, and thus the pattern collapse can also be suppressed. It is presumed that these effects result in excellent limit resolution.

Hereinafter, a case where the limit resolution is further enhanced is also referred to as "further enhanced effects of the present invention are provided".

It is preferable that the pattern forming method have the step 1, the step 2, the step 3, and the optional step 4 in this order. In addition, the pattern forming method may have other steps described later in addition to the steps 1 to 4.

Hereinafter, first, each step in the pattern forming method will be described in detail.

[Step 1 (Metal Resist Film Forming Step)]

A step 1 is a step of forming a metal resist film using a metal resist composition.

Examples of a method for forming a metal resist film using the metal resist composition include a method for applying the metal resist composition onto a substrate and a method for vapor-depositing a metal resist component on a substrate. The metal resist composition will be described later.

Examples of a method for applying the metal resist composition onto the substrate include a method for applying the metal resist composition onto a substrate (for example, silicon or the like) used in the manufacture of a semiconductor device such as an integrated circuit using a device such as a spinner or a coater.

As a coating method, spin coating using a spinner is preferable. A rotation speed in the case of performing the spin coating is preferably 1,000 to 3,000 rpm.

The substrate to which the metal resist composition has been applied may be dried to form a metal resist film.

Examples of the drying method include a method of heating (PreBake). The heating may be performed using means provided in a known exposure device and/or a known developing device and a hot plate.

The heating temperature is preferably 80°C to 150°C, more preferably 80°C to 140°C, and still more preferably 80°C to 130°C. The heating time is preferably 30 to 1,000 seconds, more preferably 30 to 800 seconds, and still more preferably 40 to 600 seconds. The heating may be performed once or twice or more.

From the viewpoint of forming a fine pattern with higher accuracy, a film thickness of the metal resist film is preferably 10 to 90 nm, more preferably 10 to 65 nm, and still more preferably 15 to 50 nm.

In addition, an underlying film (for example, an inorganic film, an organic film, an antireflection film, or the like) may be formed between the substrate and the metal resist film.

An underlying film-forming composition preferably includes a known organic material or a known inorganic material.

A film thickness of the underlying film is preferably 10 to 90 nm, more preferably 10 to 50 nm, and still more preferably 10 to 30 nm.

Examples of the underlying film-forming composition include AL412 (manufactured by Brewer Science, Inc.) and SHB series (for example, SHB-A940 and the like, manufactured by Shin-Etsu Chemical Co., Ltd.).

A topcoat may be formed on a surface of the metal resist film on a side opposite from the substrate, using a topcoat composition.

Preferably, the topcoat composition is not mixed with the metal resist film and can be uniformly applied to a surface of the metal resist film on a side opposite from the substrate.

The topcoat composition preferably includes a resin, an additive, and an organic solvent.

Examples of a method for forming the topcoat include known topcoat forming methods, and specific examples thereof include a topcoat forming method described in paragraphs [0072] to [0082] of JP2014-059543A.

As a method for forming the topcoat, it is preferable that the topcoat including the basic compound described in JP2013-061648A is formed on a surface of the metal resist film on a side opposite from the substrate. Examples of the basic compound include basic compounds described in WO2017/002737A.

In addition, it is also preferable that the topcoat include a compound having at least one selected from the group consisting of -O-, -S-, a hydroxy group, a thiol group, -CO-, and - COO-.

[Step 2 (Exposing Step)]

A step 2 is a step of exposing the metal resist film. The exposure is performed in a patterned manner.
The step 2 is preferably a step of exposing a pattern through a photo mask.
Examples of the photo mask include known photo masks. In addition, the photo mask may be in contact with the metal resist film.
Examples of the exposure light for exposing the metal resist film include infrared light, visible light, ultraviolet light, far ultraviolet light, extreme ultraviolet light (EUV), X-rays, and electron beams.
A wavelength of the exposure light is preferably 250 nm or less, more preferably 220 nm or less, and still more preferably 1 to 200 nm. Specifically, a KrF excimer laser (wavelength: 248 nm), an ArF excimer laser (wavelength: 193 nm), an $F_2$ excimer laser (wavelength: 157 nm), X-rays, EUV (wavelength: 13 nm), or an electron beam is preferable, a KrF excimer laser, an ArF excimer laser, EUV, or an electron beam is more preferable, and EUV or an electron beam is still more preferable.
An exposure dose is not particularly limited as long as the solubility of the exposed metal resist film in a developer including an organic solvent decreases.
The exposure method in the step 2 may be liquid immersion exposure.
The step 2 may be performed once or twice or more.

[Step 3 (Developing Step)]

A step 3 is a step of subjecting the exposed metal resist film to a development treatment with a developer including an organic solvent. By performing the development treatment, the non-exposed portion in the exposed metal resist film is removed, and a pattern is formed.
In a case where the pattern forming method does not have a step 4 described later, and in a case where the pattern forming method has the step 4 described later and the rinsing liquid used in the step 4 is another chemical liquid other than the specific chemical liquid, the specific chemical liquid is used as the developer in the step 3.
On the other hand, in a case where the pattern forming method has the step 4 described later and the rinsing liquid used in the step 4 is the specific chemical liquid, the developer used in the step 3 may be the specific chemical liquid or may be another chemical liquid.
The specific chemical liquid and the other chemical liquids will be described later.

<Developing Method>

Examples of the developing method include known developing methods.
Specific examples thereof include a method in which the exposed metal resist film is immersed in a tank filled with a developer for a certain period of time (dipping method), a method in which the exposed metal resist film is developed by forming a puddle of a developer on the surface of the metal resist film using surface tension and then allowing them to stand for a certain period of time (puddle method), a method of spraying the surface of the exposed metal resist film with a developer (spraying method), and a method in which, while a nozzle from which a developer is ejected at a constant rate is scanned on a substrate having the exposed metal resist film and rotating at a constant rate, the developer is continuously ejected onto the substrate (dynamic dispensing method).
In addition, a step of stopping the development using a solvent other than the developer may be carried out after the developing step.
The development time is preferably 10 to 300 seconds and more preferably 20 to 120 seconds.
A temperature of a developer in a case of performing development is preferably 0°C to 50°C and more preferably 15°C to 35°C.

[Step 4 (Rinsing Step)]

A step 4 is a step of washing the pattern obtained by the step 3 (developing step) using a rinsing liquid including an organic solvent.

<Rinsing Method>

Examples of the rinsing method include methods similar to the developing methods in the above-described step 3 (for example, a dipping method, a puddle method, a spraying method, a dynamic dispensing method, and the like).
The treatment time is preferably 10 to 300 seconds and more preferably 10 to 120 seconds.
The temperature of the rinsing liquid is preferably 0°C to 50°C and more preferably 15°C to 35°C.

[Other Steps]

The pattern forming method may further include other steps in addition to the above-described steps 1 to 4.
Examples of the other steps include a post exposure bake step, a post bake step, an etching step, and a purification step.

<Post Exposure Bake Step>

It is preferable that the pattern forming method have a post exposure bake (PEB) step after the step 2 (exposing step) is performed and before the step 3 (developing step) is performed.
The heating temperature of the post exposure bake is preferably 80°C to 200°C, more preferably 80°C to 180°C, and still more preferably 80°C to 150°C. The heating time is preferably 10 to 1,000 seconds, more preferably 10 to 180 seconds, and still more preferably 30 to 120 seconds.
The post exposure bake may be performed using means provided in a known exposure device and/or developing device, and a hot plate. In addition, the post exposure bake may be performed once or twice or more.

<Post Bake Step>

It is preferable that the pattern forming method have a step of heating the pattern (post bake step) after the step 4 (rinsing step). Through the post bake (PB) step, the developer and the rinsing liquid remaining between portions of the pattern and inside the pattern can be removed, and the surface roughness of the pattern can be improved.
The heating temperature in the post bake step is preferably 40°C to 250°C and more preferably 80°C to 200°C.
The heating time in the post bake step is preferably 10 to 180 seconds and more preferably 30 to 120 seconds.

<Etching Step>

The pattern forming method may have an etching step of etching a substrate using the formed pattern as a mask.
Examples of the etching method include known etching methods. Specific examples thereof include methods described in Proceedings of International Society for Optics and Photonics (Proc. of SPIE), Vol. 6924, 692420 (2008), "Chapter 4, Etching" of "Semiconductor Process Textbook", 4th edition, issued in 2007, publisher: SEMI Japan", and JP2009-267112A.

<Purification Step>

The pattern forming method may have a purification step of purifying the metal resist composition, the developer, the rinsing liquid, and/or various other components (for example, an underlying film-forming composition, a topcoat-forming composition, and the like) used in the pattern forming method.
Examples of the purification method include known purification methods, and a method of filtering using a filter or a method of using an adsorbing material is preferable.
The pore diameter of the filter is often 1 μm or less, preferably 500 nm or less, more preferably less than 100 nm, still more preferably 10 nm or less, and particularly preferably 5 nm or less. The lower limit thereof is often 0.01 nm or more.
The material of the filter is preferably polytetrafluoroethylene, polyethylene, or nylon. The filter may be formed of a composite material in which the filter material and an ion exchange medium are combined. As the filter, a filter that has been washed in advance with an organic solvent may be used.
In the method of filtering using a filter, a plurality of types of filters may be connected in series or in parallel with each other and used. In a case where a plurality of types of filters are used, filters having different pore diameters and/or composed of different materials may be used in combination. In addition, the substance to be purified may be filtered once or twice or more. In a case of the method of filtering two or more times, the filtration may be performed while circulating.
In the method of using an adsorbing material, only the adsorbing material may be used, or the filter and the adsorbing material described above may be used in combination.
Examples of the adsorbing material include known adsorbing materials, and specific examples thereof include inorganic adsorbing materials such as silica gel and zeolite, and organic adsorbing materials such as activated carbon.
In manufacturing of the metal resist composition, for example, it is preferable that various components such as the specific metal compound which can be included in the metal resist composition be dissolved in an organic solvent, and then the solution be filtered while being circulated through a plurality of filters composed of different materials. Specifically, a polyethylene filter having a pore diameter of 50 nm, a nylon filter having a pore diameter of 10 nm, and a polyethylene filter having a pore diameter of 3 nm may be connected in this order, and the circulation filtration may be performed 10 times or more.

The metal resist composition is preferably filtered using a filter and then fills a clean container. From the viewpoint of suppressing deterioration over time, it is preferable that the metal resist composition filling the container be further stored in a refrigerator.

From the viewpoint of preventing failure of the chemical liquid pipe and various parts (for example, a filter, an O-ring, a tube, and the like) due to electrostatic charge and electrostatic discharge, the liquids including an organic solvent, such as the developer and the rinsing liquid, may include a conductive compound.

Examples of the conductive compound include methanol. From the viewpoint of maintaining the development performance or the rinsing performance, the content of the conductive compound in the developer with respect to the total mass of the developer or the content of the conductive compound in the rinsing liquid with respect to the total mass of the rinsing liquid is preferably 10% by mass or less, and more preferably 5% by mass or less. The lower limit thereof is often 0.01% by mass or more.

[Specific Chemical Liquid]

The specific chemical liquid is a chemical liquid including two or more kinds of organic solvents and includes at least an organic solvent having a $\delta_P + \delta_H$ in Hansen solubility parameters of less than 9.8 $(J/cm^3)^{0.5}$.

In other words, the specific chemical liquid is a chemical liquid including two or more kinds of organic solvents, in which at least one of the organic solvents included in the specific chemical liquid is an organic solvent having a $\delta_P + \delta_H$ in Hansen solubility parameters of less than 9.8 $(J/cm^3)^{0.5}$. In addition, the specific chemical liquid may include an organic solvent having a $\delta_P + \delta_H$ in the Hansen solubility parameters of 9.8 $(J/cm^3)^{0.5}$ or more (hereinafter also referred to as "organic solvent Y") as long as the specific chemical liquid includes an organic solvent having a $\delta_P + \delta_H$ in the Hansen solubility parameters of less than 9.8 $(J/cm^3)^{0.5}$ (hereinafter, also referred to as "organic solvent X").

As for a suitable aspect of the specific chemical liquid, an aspect of a chemical liquid including two or more kinds of organic solvents, the chemical liquid including at least an organic solvent having a $\delta_P + \delta_H$ in Hansen solubility parameters of less than 8.0 $(J/cm^3)^{0.5}$, is preferable, and an aspect of a chemical liquid including two or more kinds of organic solvents, the chemical liquid including at least an organic solvent having a $\delta_P + \delta_H$ in Hansen solubility parameters of 5.0 $(J/cm^3)^{0.5}$ or less, is more preferable.

The lower limit value of $\delta_P + \delta_H$ in the Hansen solubility parameters is not particularly limited, but is preferably 0 $(J/cm^3)^{0.5}$ or more.

In addition, as for another suitable aspect of the specific chemical liquid, an aspect of a chemical liquid including two or more kinds of organic solvents, in which the chemical liquid includes an organic solvent X described later and an organic solvent Y described later, is also preferable.

In the present specification, the Hansen solubility parameters mean Hansen solubility parameters described in "Hansen Solubility Parameters: A Users Handbook, Second Edition" (pp. 1 to 310, CRC Press, published in 2007). That is, the Hansen solubility parameters represent solubility by a multi-dimensional vector (dispersion term: $\delta_D$, polar term: $\delta_P$, and hydrogen-bonding term: $\delta_H$), and the three parameters also mean coordinates of a point in a three-dimensional space called Hansen space. The unit of each term of the Hansen solubility parameters is $(J/cm^3)^{0.5}$.

Therefore, $\delta_P + \delta_H$ is the total value of the polar term ($\delta_P$) and the hydrogen-bonding term ($\delta_H$) in the Hansen solubility parameters.

$\delta_P + \delta_H$ in the Hansen solubility parameters of the organic solvent X is less than 9.8 $(J/cm^3)^{0.5}$, preferably less than 8.0 $(J/cm^3)^{0.5}$, more preferably 5.0 $(J/cm^3)^{0.5}$ or less, and still more preferably 1.0 $(J/cm^3)^{0.5}$ or less. The lower limit is preferably 0 $(J/cm^3)^{0.5}$ or more.

$\delta_D$ in the Hansen solubility parameters of the organic solvent X is preferably 0.0 to 30.0 $(J/cm^3)^{0.5}$ and more preferably 10.0 to 20.0 $(J/cm^3)^{0.5}$.

$\delta_P$ in the Hansen solubility parameters of the organic solvent X is preferably 0.0 to 9.0 $(J/cm^3)^{0.5}$, more preferably 0.0 to 4.0 $(J/cm^3)^{0.5}$, still more preferably 0.0 to 2.0 $(J/cm^3)^{0.5}$, and particularly preferably 0.0 to 1.0 $(J/cm^3)^{0.5}$.

$\delta_H$ in the Hansen solubility parameters of the organic solvent X is preferably 0.0 to 9.0 $(J/cm^3)^{0.5}$, more preferably 0.0 to 5.5 $(J/cm^3)^{0.5}$, still more preferably 0.0 to 2.0 $(J/cm^3)^{0.5}$, and particularly preferably 0.0 to 1.0 $(J/cm^3)^{0.5}$.

The boiling point of the organic solvent X is preferably 100°C or higher and more preferably 150°C or higher. The upper limit thereof is often 260°C or lower, and preferably 220°C or lower.

$\delta_P + \delta_H$ in the Hansen solubility parameters of the organic solvent Y is 9.8 $(J/cm^3)^{0.5}$ or more. The upper limit is preferably 30.0 $(J/cm^3)^{0.5}$ or less and more preferably 20.0 $(J/cm^3)^{0.5}$ or less.

$\delta_D$ in the Hansen solubility parameters of the organic solvent Y is preferably 0.0 to 30.0 $(J/cm^3)^{0.5}$ and more preferably 10.0 to 20.0 $(J/cm^3)^{0.5}$.

$\delta_P$ in the Hansen solubility parameters of the organic solvent Y is preferably 0.0 to 20.0 $(J/cm^3)^{0.5}$ and more preferably 0.0 to 10.0 $(J/cm^3)^{0.5}$.

$\delta_H$ in the Hansen solubility parameters of the organic solvent Y is preferably 0.0 to 20.0 $(J/cm^3)^{0.5}$ and more preferably 3.0 to 15.0 $(J/cm^3)^{0.5}$.

The boiling point of the organic solvent Y is preferably 100°C or higher and more preferably 110°C or higher. The upper limit thereof is often 260°C or lower, and preferably 200°C or lower.

The specific chemical liquid may be a mixture of the organic solvents and water.

The content of water is preferably less than 50% by mass, more preferably less than 20% by mass, and still more preferably less than 10% by mass with respect to the total mass of the specific chemical liquid, and it is particularly preferable that the specific chemical liquid include substantially no water (for example, less than 1% by mass).

The content of the organic solvents in the specific chemical liquid is preferably 50% to 100% by mass, more preferably 80% to 100% by mass, still more preferably 90% to 100% by mass, and particularly preferably 95% to 100% by mass with respect to the total mass of the specific chemical liquid.

The content of the organic solvent X in the specific chemical liquid is preferably 1% to 80% by mass, more preferably 1% to 50% by mass, and still more preferably 5% to 30% by mass with respect to the total mass of the specific chemical liquid.

The content of the organic solvent Y in the specific chemical liquid is preferably 20% to 99% by mass, more preferably 50% to 99% by mass, and still more preferably 70% to 95% by mass with respect to the total mass of the specific chemical liquid.

The organic solvents included in the specific chemical liquid are preferably at least one selected from the group consisting of an ester solvent, a hydrocarbon solvent, an alcohol solvent, an ether solvent, a ketone solvent, and an amide solvent, and more preferably at least one selected from the group consisting of an ester solvent, a hydrocarbon solvent, an alcohol solvent, an ether solvent, a ketone solvent, and an amide solvent.

In addition, at least one of the organic solvents included in the specific chemical liquid is preferably an ester solvent, a hydrocarbon solvent, an alcohol solvent, an ether solvent, or a ketone solvent, and the organic solvents included in the specific chemical liquid more preferably include an ester solvent, an alcohol solvent, an ether solvent, or a ketone solvent, and a hydrocarbon solvent.

Preferably, the specific chemical liquid includes an organic solvent A and an organic solvent B, a boiling point of the organic solvent A is higher than a boiling point of the organic solvent B, and $\delta_P + \delta_H$ in Hansen solubility parameters of the organic solvent A is smaller than $\delta_H + \delta_P$ in Hansen solubility parameters of the organic solvent B.

In other words, from the viewpoint of providing further enhanced effects of the present invention, it is preferable that, in any two types of organic solvents in the specific chemical liquid, the boiling point of one organic solvent be higher than the boiling point of the other organic solvent, and $\delta_P + \delta_H$ in the Hansen solubility parameters of the one organic solvent be lower than $\delta_P + \delta_H$ of the other organic solvent.

It is more preferable that one of the organic solvents A and B which is included at a lower content have a higher boiling point and a smaller $\delta_P + \delta_H$ in the Hansen solubility parameters.

<Specific Examples of Ester Solvent, Hydrocarbon Solvent, Alcohol Solvent, Ether Solvent, and Ketone Solvent>

Hereinafter, specific examples of the ester solvent, the hydrocarbon solvent, the alcohol solvent, the ether solvent, the ketone solvent, and the amide solvent which can be suitably used as the organic solvents included in the specific chemical liquid will be described in detail.

(Ester Solvent)

The number of carbon atoms in the ester solvent is preferably 2 to 12 and more preferably 5 to 10.

The ester solvent has a heteroatom. Examples of the heteroatom include an oxygen atom, and it is preferable that the ester solvent have only an oxygen atom as the heteroatom.

The number of heteroatoms in the ester solvent is preferably 2 to 6, more preferably 2 or 3, and still more preferably 2. In addition, the ester solvent may have one or two or more - COO-, and preferably has only one -COO-.

Examples of the ester solvent include methyl acetate, butyl acetate, ethyl acetate, propyl acetate, isopropyl acetate, pentyl acetate, isopentyl acetate, hexyl acetate, propylene glycol monomethyl ether acetate (PGMEA), ethylene glycol monoethyl ether acetate, diethylene glycol monobutyl ether acetate, diethylene glycol monoethyl ether acetate, ethyl-3-ethoxypropionate, 3-methoxybutyl acetate, 1-methoxy-2-propyl acetate, 3-methyl-3-methoxybutyl acetate, methyl formate, ethyl formate, butyl formate, propyl formate, ethyl lactate, butyl lactate, propyl lactate, butyl butyrate, methyl 2-hydroxyisobutyrate, isoamyl butyrate, isobutyl isobutyrate, ethyl propionate, propyl propionate, butyl propionate, and isobutyl propionate.

The ester solvent is preferably propyl acetate, butyl acetate, hexyl acetate, PGMEA, ethyl lactate, isoamyl butyrate, ethyl propionate, propyl propionate, butyl propionate, or isobutyl propionate.

The boiling point of the ester solvent is preferably 100°C to 200°C, more preferably 120°C to 200°C, and still more preferably 120°C to 180°C.

(Hydrocarbon Solvent)

Examples of the hydrocarbon solvent include an aliphatic hydrocarbon solvent and an aromatic hydrocarbon solvent. The aliphatic hydrocarbon solvent may be a saturated aliphatic hydrocarbon solvent or an unsaturated aliphatic hydrocarbon solvent and is preferably a saturated aliphatic hydrocarbon solvent.
The number of carbon atoms in the hydrocarbon solvent is preferably 3 to 20, more preferably 8 to 12, and still more preferably 9 to 11.
The aliphatic hydrocarbon solvent may be any of linear, branched, or cyclic, and is preferably linear. The aromatic hydrocarbon solvent may be monocyclic or polycyclic.
Examples of the hydrocarbon solvent include saturated aliphatic hydrocarbon solvents such as pentane, hexane, octane, nonane, decane, undecane, dodecane, hexadecane, 2,2,4-trimethylpentane, and 2,2,3-trimethylhexane; and aromatic hydrocarbon solvents such as mesitylene, cumene, pseudocumene, 1,2,4,5-tetramethylbenzene, p-cymene, toluene, xylene, ethylbenzene, propylbenzene, 1-methylpropylbenzene, 2-methylpropylbenzene, dimethylbenzene, diethylbenzene, ethylmethylbenzene, trimethylbenzene, ethyldimethylbenzene, and dipropylbenzene.
The hydrocarbon solvent is preferably a saturated aliphatic hydrocarbon solvent, more preferably at least one selected from the group consisting of octane, nonane, decane, undecane, and dodecane, and still more preferably at least one selected from the group consisting of nonane, decane, and undecane.
The boiling point of the hydrocarbon solvent is preferably 100°C to 260°C, more preferably 120°C to 240°C, still more preferably 125°C to 220°C, and particularly preferably 140°C to 220°C.

(Ketone Solvent)

The number of carbon atoms in the ketone solvent is preferably 3 to 20, more preferably 3 to 15, and still more preferably 3 to 12.
Examples of the ketone solvent include 1-octanone, 2-octanone, 1-nonanone, 2-nonanone, acetone, 2-heptanone, 4-heptanone, 1-hexanone, 2-hexanone, diisobutyl ketone, cyclohexanone, methylcyclohexanone, phenylacetone, methyl ethyl ketone, methyl isobutyl ketone, acetyl acetone, acetonylacetone, ionone, diacetonyl alcohol, acetyl carbinol, acetophenone, methyl naphthyl ketone, isophorone, and propylene carbonate.
The ketone solvent is preferably, cyclohexanone, 2-heptanone, or diisobutyl ketone.
The boiling point of the ketone solvent is preferably 100°C to 200°C, more preferably 120°C to 180°C, and still more preferably 150°C to 180°C.

(Alcohol Solvent)

Examples of the alcohol solvent include methyl alcohol, ethyl alcohol, n-propyl alcohol, isopropyl alcohol, n-butyl alcohol, sec-butyl alcohol, tert-butyl alcohol, isobutyl alcohol, n-hexyl alcohol, 4-methyl-2-pentanol, n-heptyl alcohol, n-octyl alcohol, n-decanol, ethylene glycol, diethylene glycol, triethylene glycol, ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol, and 4-methyl-2-pentanol is preferable.
A boiling point of the alcohol solvent is preferably 80°C to 180°C, more preferably 80°C to 160°C, and still more preferably 80°C to 150°C.

(Ether Solvent)

Examples of the ether solvent include dioxane, tetrahydrofuran, and diisobutyl ether, and diisobutyl ether is preferable.
A boiling point of the ether solvent is preferably 100°C to 180°C, more preferably 100°C to 160°C, and still more preferably 100°C to 140°C.

(Amide Solvent)

Examples of the amide solvent include N-methyl-2-pyrrolidone, N,N-dimethylacetamide, N,N-dimethylformamide, hexamethylphosphoric triamide, and 1,3-dimethyl-2-imidazolidinone.
The boiling point of the amide solvent is preferably 140°C to 250°C and more preferably 150°C to 230°C.

<Example of Suitable Aspects of Composition of Organic Solvents in Specific Chemical Liquid>

Hereinafter, an example of suitable aspects of the composition of the organic solvents in the specific chemical

liquid will be described.

(Aspect 1)

The specific chemical liquid includes at least a first organic solvent and a second organic solvent, $\delta_P + \delta_H$ in Hansen solubility parameters of at least one of the first organic solvent or the second organic solvent is less than 9.8 $(J/cm^3)^{0.5}$, the second organic solvent is an organic solvent selected from the group consisting of a hydrocarbon solvent, an ester solvent, an alcohol solvent, an ether solvent, and a ketone solvent (provided that the kind of the ester solvent used as the second organic solvent is different from that of the ester solvent used as the first organic solvent), and the content of the first organic solvent is 40% by mass or more (preferably 50% by mass or more and more preferably 60% by mass or more) with respect to the total content of the first organic solvent and the second organic solvent. The upper limit is preferably 95% by mass or less and more preferably 90% by mass or less.

(Aspect 2)

The specific chemical liquid includes at least a first organic solvent and a second organic solvent, $\delta_P + \delta_H$ in Hansen solubility parameters of at least one of the first organic solvent or the second organic solvent is less than 9.8 $(J/cm^3)^{0.5}$, the first organic solvent is a hydrocarbon solvent, the second organic solvent is an organic solvent selected from the group consisting of a hydrocarbon solvent, an ester solvent, an alcohol solvent, an ether solvent, and a ketone solvent (provided that the kind of the hydrocarbon solvent used as the second organic solvent is different from that of the hydrocarbon solvent used as the first organic solvent), and the content of the first organic solvent is 30% by mass or less (preferably, 20% by mass or less) with respect to the total content of the first organic solvent and the second organic solvent. The lower limit is preferably 10% by mass or more and more preferably 15% by mass or more.

(Aspect 3)

The specific chemical liquid includes at least a first organic solvent and a second organic solvent, $\delta_P + \delta_H$ in Hansen solubility parameters of at least one of the first organic solvent or the second organic solvent is less than 9.8 $(J/cm^3)^{0.5}$, the first organic solvent is a ketone solvent, the second organic solvent is an organic solvent selected from the group consisting of an alcohol solvent and a ketone solvent (provided that the kind of the ketone solvent used as the second organic solvent is different from that of the ketone solvent used as the first organic solvent), and the content of the first organic solvent is 30% to 70% by mass (preferably, 40% to 60% by mass) with respect to the total content of the first organic solvent and the second organic solvent.

(Aspect 4)

The specific chemical liquid includes at least a first organic solvent and a second organic solvent, $\delta_P + \delta_H$ in Hansen solubility parameters of at least one of the first organic solvent or the second organic solvent is less than 9.8 $(J/cm^3)^{0.5}$, the first organic solvent is an ester solvent, the second organic solvent is a hydrocarbon solvent, and the mass ratio (content of first organic solvent/content of second organic solvent) of the content of the first organic solvent to the content of the second organic solvent is 1 to 50 (preferably 3 to 20 and more preferably 6 to 15).

In Aspects 1 to 4 above, the total content of the first organic solvent and the second organic solvent is preferably 80% to 100% by mass, more preferably 90% to 100% by mass, and still more preferably 95% to 100% by mass with respect to the total content of the organic solvents in the specific chemical liquid. In a case where the specific chemical liquid includes an organic solvent other than the first organic solvent and the second organic solvent, examples of the other organic solvent include known organic solvents other than those described above.

**In** Aspects 1 to 4 above, as a relationship between the boiling points and $\delta_P + \delta_H$ in the Hansen solubility parameters of the first organic solvent and the second organic solvent, it is preferable that the boiling point of one organic solvent of the first organic solvent and the second organic solvent be higher than that of the other organic solvent and the $\delta_P + \delta_H$ in the Hansen solubility parameters of the one organic solvent is smaller than that of the other organic solvent. It is more preferable that one of the first and second organic solvents which is included at a lower content have a higher boiling point and a smaller $\delta_P + \delta_H$ in the Hansen solubility parameters.

In addition, in Aspects 1 to 4 above, the boiling points of the first organic solvent and the second organic solvent are both preferably 100°C or higher and more preferably 120°C or higher.

In addition, it is preferable that the specific chemical liquid include substantially no organic solvent including 50% by mass or more of fluorine atoms. The "include substantially no" means that the content of the organic solvent including 50% by mass or more of fluorine atoms is 5% by mass or less with respect to the total mass of the specific chemical liquid, and the content of the organic solvent is preferably 3% by mass or less, more preferably 1% by mass or less, and still more

preferably 0% by mass.

<Acid Component>

The specific chemical liquid may include an acid component.
The acid component may be ionized in the chemical liquid and present in the form of ions.
The acid component is preferably at least one or more selected from the group consisting of an organic acid and an inorganic acid.
Examples of the organic acid include organic acids described later.
Examples of the inorganic acid include boric acid, nitric acid, sulfuric acid, phosphoric acid, and hydrochloric acid.

(Organic Acid)

The treatment liquid preferably includes an organic acid.
The organic acid may be dissociated or form a salt in the treatment liquid.
The content of the organic acid is 1.00% by mass or more with respect to the total mass of the treatment liquid, and from the viewpoint of further enhancing the pattern resolution, the content is preferably 3.00% by mass or more and more preferably 5.00% by mass or more.
The content of the organic acid is less than 40.00% by mass with respect to the total mass of the treatment liquid, and from the viewpoint of further enhancing the pattern resolution, the content is preferably less than 30.00% by mass and more preferably less than 20.00% by mass.
Examples of the organic acid include carboxylic acid-based organic acids such as an aliphatic carboxylic acid-based organic acid and an aromatic carboxylic acid-based organic acid, and a phosphonic acid-based organic acid, and a carboxylic acid-based organic acid is preferable and a monocarboxylic acid is more preferable.
The carboxylic acid-based organic acid is a compound having one or two or more carboxy groups.
The carboxylic acid-based organic acid may further have a hydroxy group in addition to the carboxy group.
The number of carboxy groups included in the carboxylic acid-based organic acid is preferably 1 to 10, more preferably 1 to 5, and still more preferably 1.
Examples of the aliphatic carboxylic acid-based organic acid include acetic acid, formic acid, propionic acid, butyric acid, glycolic acid, lactic acid, oxalic acid, malonic acid, succinic acid, glutaric acid, adipic acid, pimelic acid, sebacic acid, maleic acid, malic acid, citric acid, tartaric acid, and gluconic acid.
Examples of the aromatic carboxylic acid-based organic acid include phthalic acid, isophthalic acid, terephthalic acid, gallic acid, trimellitic acid, mellitic acid, and cinnamic acid.
Examples of the phosphonic acid-based organic acid include compounds described in paragraphs [0026] to [0036] of WO2018/020878A and compounds described in paragraphs [0031] to [0046] of WO2018/030006A, the contents of which are incorporated in the present specification.
The organic acid preferably includes at least one organic acid selected from the group consisting of formic acid, acetic acid, propionic acid, butyric acid, and lactic acid.
These organic acids may be used alone or in combination of two or more kinds thereof, or in combination with an inorganic acid.

<Other Components>

The specific chemical liquid may include components other than the organic solvents and the acid component.
Examples of the other components include known surfactants.
The content of the surfactant is preferably 0.001% to 5% by mass, more preferably 0.005% to 2% by mass, and still more preferably 0.01% to 0.5% by mass with respect to the total mass of the specific chemical liquid.

[Other Chemical Liquids]

As described above, in a case where the pattern forming method has the step 4, the specific chemical liquid is used in at least one of the developer in the step 3 or the rinsing liquid in the step 4. The specific chemical liquid may be used for both the developer in the step 3 and the rinsing liquid in the step 4, or the specific chemical liquid may be used in one of the developer in the step 3 and the rinsing liquid in the step 4, and another chemical liquid may be used in the other.
Other chemical liquids are chemical liquids other than the specific chemical liquid, and known developer and rinsing liquid can be applied.
Examples of organic solvents included in the other chemical liquids include a ketone solvent, an ester solvent, an alcohol solvent, an amide solvent, an ether solvent, and a hydrocarbon solvent which can be included in the organic

solvent of the above-described specific chemical liquid.
The other chemical liquids may be mixtures of an organic solvent and water.
The other chemical liquids may include other components in addition to the above components.
Examples of the other components include known organic solvents other than those described above and known surfactants.

[Metal Resist Composition]

Hereinafter, the metal resist composition used in the step 1 will be described.

<Specific Metal Compound>

The metal resist composition includes a specific metal compound.
The specific metal compound is a metal compound having at least one bond selected from the group consisting of a metal-carbon bond (M-C) and a metal-oxygen bond (M-O). M represents a metal atom.
The metal-carbon bond refers to a state in which at least one metal atom and at least one carbon atom in the specific metal compound are bonded to each other by a covalent bond, a coordinate bond, an ionic bond, a van der Waals bond, or the like. In a case where at least one metal atom and at least one carbon atom are bonded to each other by a covalent bond, the covalent bond may be any of a single bond, a double bond, and a triple bond. In addition, the metal-oxygen bond refers to a state in which at least one metal atom and at least one oxygen atom in the specific metal compound are bonded by a covalent bond, a coordinate bond, an ionic bond, a van der Waals bond, or the like. In a case where at least one metal atom and at least one oxygen atom are bonded to each other by a covalent bond, the covalent bond may be either a single bond or a double bond.
In a case where the specific metal compound has a metal-carbon bond, the specific metal compound is a so-called organometallic compound.
The number of bonds selected from the above-described group, which is included in the specific metal compound, is preferably 2 or more and more preferably 3 or more. The upper limit thereof is preferably 10 or less and more preferably 5 or less.
Examples of the metal atom constituting the specific metal compound include metal atoms of group 3 to group 16 in the periodic table, and tin, antimony, tellurium, indium, hafnium, tantalum, tungsten, bismuth, titanium, cobalt, nickel, zirconium, or palladium is preferable, and tin is more preferable.
In the present specification, a silicon atom is included in the metal atom.
Examples of the specific metal compound include a compound represented by Formula (1).

$$(R^1)_{n1}\text{-M-}(R^2)_{m1} \qquad (1)$$

In Formula (1), M represents a metal atom. $R^1$ represents an alkyl group which may have a substituent, an aliphatic unsaturated hydrocarbon group which may have a substituent, or an aryl group which may have a substituent. $R^2$ represents $-OCOR^{r1}$ or $-OR^{r2}$. $R^{r1}$ represents a hydrogen atom, an alkyl group which may have a substituent, an aliphatic unsaturated hydrocarbon group which may have a substituent, or an aryl group which may have a substituent. $R^{r2}$ represents an alkyl group which may have a substituent, an aliphatic unsaturated hydrocarbon group which may have a substituent, or an aryl group which may have a substituent. n1 + m1 represents the valence of the metal atom represented by M.
In Formula (1), M represents a metal atom.
Examples of M include a metal atom constituting the above-described specific metal compound, and tin, antimony, tellurium, indium, hafnium, tantalum, tungsten, bismuth, titanium, cobalt, nickel, zirconium, or palladium is preferable, and tin is more preferable.
In Formula (1), $R^1$ represents an alkyl group which may have a substituent, an aliphatic unsaturated hydrocarbon group which may have a substituent, or an aryl group which may have a substituent.
The alkyl group may be linear, branched, or cyclic.
The number of carbon atoms in the above-described alkyl group is preferably 1 to 30, more preferably 1 to 16, and still more preferably 1 to 5. In a case where the alkyl group represented by $R^1$ is an alkyl group having a substituent, the number of carbon atoms is a number that also includes the number of carbon atoms of the substituent.
Examples of the above-described alkyl group include a methyl group, an ethyl group, a propyl group, and a butyl group.
Examples of the substituent which may be included in the above-described alkyl group include a halogen atom, a hydroxy group, a cyano group, a nitro group, an amino group, and an aromatic ring group. As the aromatic ring group, a phenyl group is preferable. As the alkyl group having a phenyl group, a benzyl group is preferable.

The aliphatic unsaturated hydrocarbon group is an aliphatic hydrocarbon group having an unsaturated group in the group.

Examples of the unsaturated group include a double bond and a triple bond.

The above-described aliphatic unsaturated hydrocarbon group may be linear, branched, or cyclic.

The number of carbon atoms in the above-described aliphatic unsaturated hydrocarbon group is preferably 2 to 30, more preferably 2 to 16, and still more preferably 2 to 5. In a case where the aliphatic unsaturated hydrocarbon group represented by $R^1$ is an aliphatic unsaturated hydrocarbon group having a substituent, the number of carbon atoms is a number that also includes the number of carbon atoms in the substituent.

Examples of the above-described aliphatic unsaturated hydrocarbon group include a vinyl group, an ethynyl group, an allyl group, a 1-propenyl group, a 1-methyl-1-propenyl group, a 2-propenyl group, a 2-methyl-2-propenyl group, a 1-propynyl group, a 1-methyl-1-propynyl group, a 2-propynyl group, a 2-methyl-2-propynyl group, a 1-butenyl group, a 2-butenyl group, a 3-butenyl group, a 1-butynyl group, a 2-butynyl group, and a 3-butynyl group, and a vinyl group or an allyl group is preferable.

Examples of the substituent which may be included in the above-described aliphatic unsaturated hydrocarbon group include a halogen atom, a hydroxy group, a cyano group, a nitro group, an amino group, and an aromatic ring group.

The aryl group may be monocyclic or polycyclic.

The number of carbon atoms in the above-described aryl group is preferably 6 to 30, more preferably 6 to 12, and still more preferably 6 to 8. In a case where the aryl group represented by $R^1$ is an aryl group having a substituent, the number of carbon atoms is a number that also includes the number of carbon atoms in the substituent.

Examples of the above-described aryl group include a phenyl group, a naphthyl group, an anthryl group, a pyrenyl group, a phenanthrenyl group, a methylphenyl group, a dimethylphenyl group, a biphenyl group, and a fluorenyl group, and a phenyl group or a naphthyl group is preferable.

Examples of the substituent which may be included in the above-described aryl group include an alkyl group, a halogen atom, a hydroxy group, a cyano group, a nitro group, an amino group, and an aromatic ring group.

In Formula (1), $R^2$ represents $-OCOR^{r1}$ or $-OR^{r2}$. $R^{r1}$ represents a hydrogen atom, an alkyl group which may have a substituent, an aliphatic unsaturated hydrocarbon group which may have a substituent, or an aryl group which may have a substituent. $R^{r2}$ represents an alkyl group which may have a substituent, an aliphatic unsaturated hydrocarbon group which may have a substituent, or an aryl group which may have a substituent.

$R^2$ is preferably $-OCOR^{r1}$.

Examples of the alkyl group which may have a substituent, the aliphatic unsaturated hydrocarbon group which may have a substituent, and the aryl group which may have a substituent, each represented by $R^{r1}$ or $R^{r2}$, include the alkyl group which may have a substituent, the aliphatic unsaturated hydrocarbon group which may have a substituent, and the aryl group which may have a substituent, each represented by $R^1$ described above.

In Formula (1), n1 + m1 represents a valence of the metal atom represented by M.

n1 + m1 is appropriately selected according to the possible valence of the metal atom represented by M. In other words, n1 + m1 is a value that varies depending on the type of the metal atom represented by M. Here, n1 + m1 represents an integer of 1 or more.

n1 is preferably an integer of 0 to 2 and more preferably 1.

m1 is preferably an integer of 0 to 4 and more preferably 3.

In a case where a plurality of $R^1$'s are present, $R^1$'s may be the same or different from each other. In a case where a plurality of $R^2$'s are present, $R^2$'s may be the same or different from each other.

Examples of the specific metal compound also include a compound represented by Formula (2) and a condensate thereof.

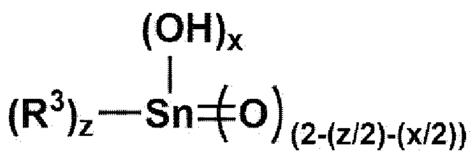 (2)

$$0 < z \leqq 2 \qquad (2\text{-}1)$$

$$0 < z + x \leqq 4 \qquad (2\text{-}2)$$

In Formula (2), $R^3$ represents a hydrocarbon group which may have a substituent. z and x represent numbers satisfying a relationship of Expression (2-1) and a relationship of Expression (2-2).

Examples of the hydrocarbon group include an alkyl group which may have a substituent, an aliphatic unsaturated hydrocarbon group which may have a substituent, and an aryl group which may have a substituent. Suitable aspects of the alkyl group, the aliphatic unsaturated hydrocarbon group, and the aryl group include suitable aspects of each of the groups represented by $R^1$.

In a case where a plurality of $R^3$'s are present, $R^3$'s may be the same or different from each other.

Examples of the specific metal compound also include a compound represented by Formula (3).

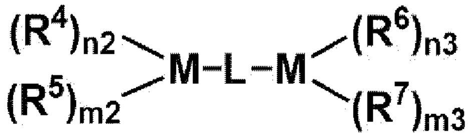

(3)

In Formula (3), M represents a metal atom. L represents a single bond or a divalent linking group. $R^4$ and $R^6$ each independently represent an alkyl group which may have a substituent, an aliphatic unsaturated hydrocarbon group which may have a substituent, or an aryl group which may have a substituent. $R^5$ and $R^7$ each independently represent -OCO$R^{r3}$ or -O$R^{r4}$. $R^{r3}$ represents a hydrogen atom, an alkyl group which may have a substituent, an aliphatic unsaturated hydrocarbon group which may have a substituent, or an aryl group which may have a substituent. $R^{r4}$ represents an alkyl group which may have a substituent, an aliphatic unsaturated hydrocarbon group which may have a substituent, or an aryl group which may have a substituent. n2 + m2 and n3 + m3 each independently represent the valence of the metal atom represented by M - 1.

In Formula (3), examples of M include the metal atom represented by M in Formula (1).

In Formula (3), examples of $R^4$ and $R^6$ include the groups represented by $R^1$ described above.

In Formula (3), examples of $R^5$ and $R^7$ include the groups represented by $R^2$ described above.

In Formula (3), examples of $R^{r3}$ and $R^{r4}$ include the groups represented by $R^{rt}$ and $R^{r2}$ described above, respectively.

In a case where a plurality of $R^4$'s are present, $R^4$'s may be the same or different from each other. In a case where a plurality of $R^5$'s are present, $R^5$'s may be the same or different from each other. In a case where a plurality of $R^6$'s are present, $R^6$'s may be the same or different from each other. In a case where a plurality of $R^7$'s are present, $R^7$'s may be the same or different from each other.

In Formula (3), L represents a single bond or a divalent linking group.

Examples of the divalent linking group include an alkylene group and an arylene group.

In Formula (3), n2 + m2 and n3 + m3 each independently represent the valence of the metal atom represented by M - 1.

n2 + m2 and n3 + m3 are each a "valence of the metal atom represented by M - 1" and are appropriately selected according to the possible valence of the metal atom represented by M.

Examples of the specific metal compound also include a compound represented by Formula (4), a hydrolysate of the compound, and a condensate of the hydrolysate.

$$(R^8)_{nz}\text{-Sn-}(X)_{4-nz} \qquad (4)$$

In Formula (4), $R^8$ represents a hydrocarbon group which may have a substituent. X represents a hydrolyzable group. nz represents 1 or 2.

Examples of the hydrocarbon group include the groups represented by $R^1$ described above.

Examples of X include -NH$R^{x1}$, -N$R^{x1}R^{x2}$, -OSi$R^{x1}R^{x2}R^{x3}$, -N(Si$R^{x1}_3$)($R^{x2}$), - N(Si$R^{x1}_3$)(Si$R^{x2}_3$), an azide group, -C≡C$R^{x1}$, -NH(CO$R^{x1}$), -N$R^{x1}$(CO$R^{x2}$), -N$R^{x1}$C(N$R^{x2}$)$R^{x3}$ (amidinate group), and an imide group, and -NH$R^{x1}$ or -N$R^{x1}R^{x2}$ is preferable. $R^{x1}$ to $R^{x3}$ each independently represent a hydrocarbon group having 1 to 10 carbon atoms. $R^{x1}$ to $R^{x3}$ are preferably an alkyl group having 1 to 10 carbon atoms.

In a case where a plurality of $R^8$'s are present, $R^8$'s may be the same or different from each other. In a case where a plurality of X's are present, X's may be the same or different from each other.

The specific metal compound is preferably a compound represented by Formula (5).

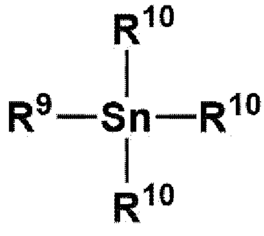

(5)

In Formula (5), $R^9$ represents an alkyl group which may have a substituent, an aliphatic unsaturated hydrocarbon group which may have a substituent, or an aryl group which may have a substituent. Each $R^{10}$ represents -OCOR$^{r5}$ or -OR$^{r6}$. $R^{r5}$ represents a hydrogen atom, an alkyl group which may have a substituent, an aliphatic unsaturated hydrocarbon group which may have a substituent, or an aryl group which may have a substituent. $R^{r6}$ represents an alkyl group which may have a substituent, an aliphatic unsaturated hydrocarbon group which may have a substituent, or an aryl group which may have a substituent.

In Formula (5), $R^9$, $R^{10}$, $R^{r5}$, and $R^{r6}$ have the same meaning as $R^1$, $R^2$, $R^{r1}$, and $R^{r2}$, respectively, in Formula (1), and suitable aspects thereof are also the same.

The plurality of $R^{10}$'s present may be the same or different from each other.

The specific metal compound preferably includes at least one selected from the group consisting of a compound represented by Formula (1), a compound represented by Formula (2), and a condensate of the compound represented by Formula (2), more preferably includes at least one selected from the group consisting of a compound represented by Formula (5), a compound represented by Formula (2), and a condensate of the compound represented by Formula (2), and still more preferably includes a compound represented by Formula (5).

Examples of the specific metal compound also include specific metal compounds described in JP2021-047426A, JP2021-179606A, JP6805244B, and WO2019/111727A.

The specific metal compounds may be used alone or in combination of two or more kinds thereof.

The content of the specific metal compound is preferably 50% to 100% by mass and more preferably 80% to 100% by mass with respect to the total solid content of the metal resist composition.

<Organic Acid>

The metal resist composition may include an organic acid.

Examples of the organic acid include carboxylic acids, sulfonic acids, sulfinic acids, organophosphinic acids, organophosphonic acids, phenols, enols, thiols, imidic acids, oximes, and sulfonamides.

Examples of the carboxylic acid include monocarboxylic acids such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids such as oxalic acid, malonic acid, maleic acid, methylmalonic acid, fumaric acid, adipic acid, sebacic acid, phthalic acid, and tartaric acid; and carboxylic acids having three or more carboxy groups, such as citric acid.

The organic acids may be used alone or in combination of two or more kinds thereof.

The content of the organic acid is preferably 0% to 10% by mass and more preferably 1% to 5% by mass with respect to the total solid content of the metal resist composition.

<Surfactant>

The metal resist composition may include a surfactant.

In a case where the metal resist composition includes a surfactant, a pattern having more excellent adhesiveness and having less development defects can be formed.

The surfactant is preferably a fluorine-based surfactant or a silicon-based surfactant.

Examples of the fluorine-based surfactant and the silicon-based surfactant include surfactants described in paragraphs [0218] and [0219] of WO2018/193954A.

The surfactants may be used alone or in combination of two or more kinds thereof.

In a case where the metal resist composition includes a surfactant, the content of the surfactant is preferably 0.0001% to 2% by mass, and more preferably 0.0005% to 1% by mass with respect to the total solid content of the metal resist composition.

<Organic Solvent>

The metal resist composition may include an organic solvent.

Examples of the organic solvent include the organic solvents which may be included in the specific chemical liquid and the other chemical liquids described above.

The content of the organic solvent in the metal resist composition is preferably an amount at which the concentration of solid contents is 0.5% to 30% by mass, and more preferably an amount at which the concentration of solid contents is 1% to 20% by mass. In a case of the above aspect, the coating property of the metal resist composition can be improved.

<Other Additives>

The metal resist composition may include other additives such as water, a dissolution inhibiting compound, a dye, a plasticizer, a photosensitizer, a light absorbing agent, a compound (for example, a phenol compound having a molecular weight of 1,000 or less, an alicyclic or aliphatic compound including a carboxylic acid group, and the like) which promotes solubility in a developer, and the like.

The metal resist composition is suitably used as a photosensitive composition for EUV light or electron beams.

EUV light has a wavelength of 13.5 nm, which is shorter than the wavelength of ArF (wavelength: 193 nm) light or the like, and thus provides a smaller number of incident photons when exposure is performed with the same sensitivity. Therefore, "photon shot noise", which is stochastic variations in the number of photons, exerts a great influence, resulting in degradation of line edge roughness (LER) and bridge defects. In order to reduce the photon shot noise, a method of increasing the exposure dose to increase the number of incident photons may be employed; however, this method is a trade-off with the demand for higher sensitivity.

It should be noted that, although the exposure with EUV light has been described as an example, the same problem often occurs even in a case where the exposure is performed with an electron beam.

[Method for Manufacturing Electronic Device]

The present invention also relates to a method for manufacturing an electronic device, the method including the above-described pattern forming method.

The electronic device is suitably mounted on electrical and electronic equipment (for example, home appliances, office automation (OA), media-related equipment, optical equipment, communication equipment, and the like).

[Examples]

Hereinafter, the present invention will be described in more detail with reference to examples. The materials, the amounts used, the proportions, the processes, the procedures of processes, and the like described in the following examples can be appropriately changed as long as the changes do not depart from the spirit and scope of the present invention. Therefore, the scope of the present invention should not be construed as being limited by the following examples.

[Preparation of Metal Resist Composition]

[Metal Resist Composition R-1]

A metal resist precursor solution was prepared by adding a monobutyltin oxide hydrate (BuSnOOH) powder (0.209 g, TCI America) to 4-methyl-2-pentanol (10 mL). The solution was placed in a sealed vial and stirred for 24 hours. The obtained mixture was centrifugally separated at 4,000 rpm for 15 minutes and filtered through a 0.45 μm polytetrafluoroethylene (PTFE) syringe filter to remove the insoluble material, thereby obtaining a metal resist composition R-1.

The organic solvent in the metal resist composition R-1 was removed and the composition was baked at 600°C, and the content of Sn was 0.093 M in the residue mass of $SnO_2$. In addition, the dynamic light scattering (DLS) analysis of the metal resist precursor solution was performed using a Moebius device (Wyatt Technology). As a result, the distribution matched a unimodal distribution of particles having an average particle diameter of 2 nm and the diameter matched a diameter reported for a dodecamer butyltin hydroxide oxide polyatomic cation (Eychenne-Baron et al., Organometallics, 19, 1940-1949 (2000)).

[Metal Resist Composition R-2]

Compound 1 (2.4 g) synthesized by a known method and citric acid (0.1 g) were dissolved in 1-methoxy-2-propyl acetate (97.5 g), and the resulting solution was filtered through a 0.1 μm PTFE syringe filter to obtain a metal resist composition R-2.

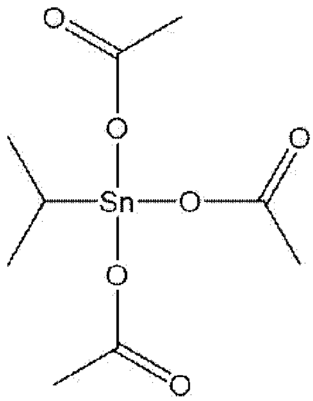

Compound 1

[Pattern Formation by EUV Exposure]

An underlying film-forming composition SHB-A940 (manufactured by Shin-Etsu Chemical Co., Ltd.) was applied onto a silicon wafer having a diameter of 300 mm and baked at 205°C for 60 seconds to form an underlying film having a film thickness of 20 nm. The metal resist composition R-1 or R-2 was applied thereto to form a metal resist film under the conditions (film thickness and PreBake) shown in Table 2 or 3. In this manner, a silicon wafer having a metal resist film was formed.

The silicon wafer having the above-described resist film was subjected to pattern exposure using an EUV scanner NXE3400 (NA: 0.33, manufactured by ASML) while the exposure dose was changed. The reticle used was a mask having a hexagonal contact hole arrangement with a pitch of 36 nm and an opening portion dimension of 21 nm. Thereafter, the silicon wafer was subjected to a post exposure bake (PEB) under the conditions shown in Table 2 or 3 and then subjected to negative tone development by performing puddling for 30 seconds with the developer shown in Table 2 or 3, and then, only in a case where there is a description, rinsed by causing the rinsing liquid shown in Table 2 or 3 to flow for 10 seconds while the wafer was rotated at a rotation speed of 1,000 rpm, and the wafer was then rotated at a rotation speed of 4,000 rpm for 30 seconds to obtain a pillar pattern having a pitch of 36 nm.

[Developer or Rinsing Liquid]

Physical properties of the organic solvents used as the developer and the rinsing liquid are shown in the following table.

The "boiling point" in the table means a boiling point (normal boiling point) at 1 atm (760 mmHg). In addition, the value of each element in the Hansen solubility parameters in an organic solvent is a value determined by the above-described method.

PGMEA: propylene glycol monomethyl ether acetate

Table 1

| | | Boiling point °C | $\delta_D$ (J/cm$^3$)$^{0.5}$ | $\delta_P$ (J/cm$^3$)$^{0.5}$ | $\delta_H$ (J/cm$^3$)$^{0.5}$ | $\delta_P + \delta_H$ (J/cm$^3$)$^{0.5}$ |
|---|---|---|---|---|---|---|
| D-1 | 2-Heptanone | 151 | 16.2 | 5.7 | 4.1 | 9.8 |
| D-2 | Isobutyl propionate | 138 | 15.5 | 4.1 | 5.0 | 9.1 |
| D-3 | Diisobutyl ether | 122 | 15.0 | 2.7 | 2.5 | 5.2 |
| D-4 | n-Undecane | 196 | 16.0 | 0.0 | 0.0 | 0.0 |
| D-5 | 4-Methyl-2-pentanol | 132 | 15.4 | 3.3 | 12.3 | 15.6 |
| D-6 | PGMEA | 146 | 15.6 | 5.6 | 9.8 | 15.4 |
| D-7 | Butyl acetate | 126 | 15.8 | 3.7 | 6.3 | 10.0 |

(continued)

| | | Boiling point °C | $\delta_D$ $(J/cm^3)^{0.5}$ | $\delta_P$ $(J/cm^3)^{0.5}$ | $\delta_H$ $(J/cm^3)^{0.5}$ | $\delta_P + \delta_H$ $(J/cm^3)^{0.5}$ |
|---|---|---|---|---|---|---|
| D-8 | Acetic acid | 118 | 14.5 | 8.0 | 13.5 | 21.5 |
| D-9 | Diisobutyl ketone | 168 | 16.0 | 3.7 | 4.1 | 7.8 |

[Evaluation]

Using a critical dimension scanning electron microscope (manufactured by Hitachi High-Tech Corporation, CG6300), 2,000 arbitrarily selected pillars formed at each exposure dose were observed, and the average pillar diameter and the quality of the pattern were evaluated. The average pillar diameter at the minimum exposure dose at which the condition that none of the observed 2,000 pillars collapsed was satisfied was defined as the limit resolution. The smaller the value, the higher the resolving power.

[Results]

The evaluation results are shown in Tables 2 and 3.

The description in parentheses accompanying a solvent indicates a content (% by mass) of the solvent with respect to the total mass of the developer or the rinsing liquid including the solvent. Specifically, the developer in Example 1 includes D-1 and D-2 as solvents, in which the content of D-1 is 80% by mass with respect to the total mass of the developer in Example 1, and the content of D-2 is 20% by mass with respect to the total mass of the developer in Example 1.

Table 1

| | Resist application conditions | | | PEB and development conditions | | | | | Properties of chemical liquid | | | | Performance evaluation results |
|---|---|---|---|---|---|---|---|---|---|---|---|---|---|
| | | | | | Developer | | Rinsing liquid | | First solvent | | Second solvent | | |
| | Metal resist composition | Film thickness (mn) | PreBake | PEB | First solvent | Second solvent | First solvent | Second solvent | $\delta_P + \delta_H$ | Boiling point °C | $\delta_P + \delta_H$ | Boiling point °C | Limit resolution (mn) |
| Example 1 | R-1 | 22 | 100°C/90 sec | 150°C/90 sec | D-1(80wt%) | D-2(20wt%) | - | - | 9.8 | 151 | 9.1 | 138 | 16.3 |
| Example 2 | R-2 | 22 | 100°C/90 sec | 150°C/90 sec | D-1(80wt%) | D-2(20wt%) | - | - | 9.8 | 151 | 9.1 | 138 | 16.2 |
| Example 3 | R-1 | 22 | 100°C/90 sec | 150°C/90 sec | D-1(100wt%) | - | D-1(80wt%) | D-2(20wt%) | 9.8 | 151 | 9.1 | 138 | 16.8 |
| Example 4 | R-2 | 22 | 100°C/90 sec | 150°C/90 sec | D-1(100w t%) | - | D-1(80wt%) | D-2(20w(%) | 9.8 | 151 | 9.1 | 138 | 16.3 |
| Example 5 | R-1 | 22 | 100°C/90 sec | 150°C/90 sec | D-1(75wt%) | D-3(25wt%) | - | - | 9.8 | 151 | 5.2 | 122 | 15.1 |
| Example 6 | R-2 | 22 | 100°C/90 sec | 150°C/90 sec | D-1(75wt%) | D-3(25wt%) | - | - | 9.8 | 151 | 5.2 | 122 | 15.0 |
| Example 7 | R-1 | 22 | 100°C/90 sec | 150°C/90 sec | D-1(100wt%) | - | D-1(75wt%) | D-3(25wt%) | 9.8 | 151 | 5.2 | 122 | 15.4 |
| Example 8 | R-2 | 22 | 100°C/90 sec | 150°C/90 sec | D-1(100wt%) | - | D-1(75wt%) | D-3(25wt%) | 9.8 | 151 | 5.2 | 122 | 15.8 |
| Example 9 | R-1 | 22 | 100°C/90 sec | 150°C/90 sec | D-1(85wt%) | D-4(15wt%) | - | - | 9.8 | 151 | 0 | 196 | 14.3 |
| Example 10 | R-2 | 22 | 100°C/90 sec | 150°C/90 sec | D-1(85wt%) | D-4(15wt%) | - | - | 9.8 | 151 | 0 | 196 | 14.3 |
| Example 11 | R-1 | 22 | 100°C/90 sec | 150°C/90 sec | D-1(100wt%) | - | D-1(85wt%) | D-4(15wt%) | 9.8 | 151 | 0 | 196 | 14.4 |
| Example 12 | R-2 | 22 | 100°C/90 sec | 150°C/90 sec | D-1(100wt%) | - | D-1(85wt%) | D-4(15wt%) | 9.8 | 151 | 0 | 196 | 14.6 |

(continued)

| | Resist application conditions | | | PEB and development conditions | | | | | Properties of chemical liquid | | | | Performance evaluation results |
|---|---|---|---|---|---|---|---|---|---|---|---|---|---|
| | Metal resist composition | Film thickness (mn) | PreBake | PEB | Developer | | Rinsing liquid | | First solvent | | Second solvent | | Limit resolution (mn) |
| | | | | | First solvent | Second solvent | First solvent | Second solvent | $\delta_P + \delta_H$ | Boiling point °C | $\delta_P + \delta_H$ | Boiling point °C | |
| Example 13 | R-1 | 22 | 100°C/90 sec | 150°C/90 sec | D-5(85wt%) | D-4(15wt%) | - | - | 15.6 | 132 | 0 | 196 | 14.2 |
| Example 14 | R-2 | 22 | 100°C/90 sec | 150°C/90 sec | D-5(85wt%) | D-4(15wt%) | - | - | 15.6 | 132 | 0 | 196 | 14.9 |
| Example 15 | R-1 | 22 | 100°C/90 sec | 150°C/90 sec | D-6(70wt%) | D-4(30wt%) | - | - | 15.4 | 146 | 0 | 196 | 14.4 |
| Example 16 | R-2 | 22 | 100°C/90 sec | 150°C/90 sec | D-6(70wt%) | D-4(30wt%) | - | - | 15.4 | 146 | 0 | 196 | 14.6 |
| Example 17 | R-1 | 22 | 100°C/90 sec | 150°C/90 sec | D-7(90wt%) | D-4(10wt%) | - | - | 10.0 | 126 | 0 | 196 | 14.3 |
| Example 18 | R-2 | 22 | 100°C/90 sec | 150°C/90 sec | D-7(90wt%) | D-4(10wt%) | - | - | 10.0 | 126 | 0 | 196 | 14.2 |
| Comparative Example 1 | R-1 | 22 | 100°C/90 sec | 150°C/90 sec | D-1(95wt%) | D-8(5wt%) | - | - | 9.8 | 151 | 21.5 | 118 | 20.1 |
| Comparative Example 2 | R-1 | 22 | 100°C/90 sec | 150°C/90 sec | D-9(100wt%) | - | - | - | 7.8 | 168 | - | - | 20.5 |

Table 3

| | Resist application conditions | | | PEB and development conditions | | | | Properties of chemical liquid | | | | | | Performance evaluation results |
|---|---|---|---|---|---|---|---|---|---|---|---|---|---|---|
| | | | | | Developer | Rinsing liquid | | First solvent | | Second solvent | | Third solvent | | |
| | Metal resist composition | Film thickness (nm) | PreBake | PEB | First solvent | Second solvent | Third solvent | $\delta_P + \delta_H$ | Boiling point °C | $\delta_P + \delta_H$ | Boiling point °C | $\delta_P + \delta_H$ | Boiling point °C | Limit resolution (nm) |
| Example 19 | R-1 | 22 | 100°C/90 sec | 150°C/90 sec | D-1 (100wt%) | D-7 (70wt%) | **D-4** (30wt%) | 9.8 | 151 | 10.0 | 126 | 0 | 196 | 14.2 |
| Example 20 | R-2 | 22 | 100°C/90 sec | 150°C/90 sec | D-1 (100wt%) | D-7 (70wt%) | **D-4** (30wt%) | 9.8 | 151 | 10.0 | 126 | 0 | 196 | 14.1 |
| Example 21 | R-1 | 22 | 100°C/90 sec | 150°C/90 sec | D-1 (100wt%) | D-7 (80wt%) | D-4 (20wt%) | 9.8 | 151 | 10.0 | 126 | 0 | 196 | 14.3 |
| Example 22 | R-2 | 22 | 100°C/90 sec | 150°C/90 sec | D-1 (100wt%) | D-7 (80wt%) | D-4 (20wt%) | 9.8 | 151 | 10.0 | 126 | 0 | 196 | 14.2 |
| Example 23 | R-1 | 22 | 100°C/90 sec | 150°C/90 sec | D-1 (100wt%) | D-7 (90wt%) | D-4 (10wt%) | 9.8 | 151 | 10.0 | 126 | 0 | 196 | 14.4 |
| Example 24 | R-2 | 22 | 100°C/90 sec | 150°C/90 sec | D-1 (100wt%) | D-7 (90wt%) | D-4 (10wt%) | 9.8 | 151 | 10.0 | 126 | 0 | 196 | 14.3 |

From the results shown in Tables 2 and 3, it was confirmed that the pattern forming method of the present invention exhibited a desired effect.

From the comparison between Examples 1 to 4 and Examples 5 to 8, it was confirmed that, in the cases where a chemical liquid including two or more kinds of organic solvents included an organic solvent having a $\delta_P + \delta_H$ in the Hansen solubility parameters of less than 8.0 $(J/cm^3)^{0.5}$, the limit resolution was further enhanced.

From the comparison between Examples 5 to 8 and Examples 9 to 18, it was confirmed that, in the cases where a chemical liquid including two or more kinds of organic solvents included the organic solvent A and the organic solvent B, the boiling point of the organic solvent A was higher than the boiling point of the organic solvent B, and $\delta_P + \delta_H$ in the Hansen solubility parameters of the organic solvent A was smaller than $\delta_H + \delta_P$ in the Hansen solubility parameters of the organic solvent B, the limit resolution was further enhanced.

A pattern was formed according to the same procedure as in Example 11, except that the film thickness of the metal resist film was changed from 22 nm to 25 nm, and the same results as in Example 11 were obtained.

In addition, a pattern was formed according to the same procedure as in Example 11, except that the conditions of the PreBake were changed from 100°C/90 seconds to 120°C/90 seconds, and the same results as in Example 11 were obtained.

In addition, a pattern was formed according to the same procedure as in Example 11, except that the conditions of the PEB were changed from 150°C/90 seconds to 120°C/90 seconds, and the same results as in Example 11 were obtained.

In addition, a pattern was formed according to the same procedure as in Example 11, except that the conditions of the PEB were changed from 150°C/90 seconds to 150°C/60 seconds, and the same results as in Example 11 were obtained.

In addition, a pattern was formed according to the same procedure as in Example 11, except that the development time was changed from 30 seconds to 15 seconds, and the same results as in Example 11 were obtained.

In addition, a pattern was formed according to the same procedure as in Example 11, except that the development time was changed from 30 seconds to 60 seconds, and the same results as in Example 11 were obtained.

In addition, a pattern was formed according to the same procedure as in Example 11, except that the rinsing time was changed from 10 seconds to 15 seconds, and the same results as in Example 11 were obtained.

In addition, a pattern was formed according to the same procedure as in Example 11, except that the rinsing time was changed from 10 seconds to 60 seconds, and the same results as in Example 11 were obtained.

## Claims

**1.** A pattern forming method comprising:

a step 1 of forming a metal resist film on a substrate using an actinic ray-sensitive or radiation-sensitive resin composition including a metal compound having at least one bond selected from the group consisting of a metal-carbon bond and a metal-oxygen bond;
a step 2 of exposing the metal resist film; and
a step 3 of obtaining a pattern by subjecting the exposed metal resist film to a development treatment with a developer including an organic solvent to remove a non-exposed portion,
wherein the pattern forming method may further comprise, after the step 3, a step 4 of washing the pattern with a rinsing liquid including an organic solvent,
in a case where the pattern forming method does not comprise the step 4 after the step 3, the developer is a chemical liquid including two or more kinds of organic solvents,
in a case where the pattern forming method comprises the step 4 after the step 3, at least one of the developer or the rinsing liquid is a chemical liquid including two or more kinds of organic solvents, and
the chemical liquid including two or more kinds of organic solvents includes at least an organic solvent in which a sum of a polar term $\delta_P$ and a hydrogen-bonding term $\delta_H$ in Hansen solubility parameters is less than 9.8 $(J/cm^3)^{0.5}$.

**2.** The pattern forming method according to claim 1, wherein the chemical liquid including two or more kinds of organic solvents includes at least an organic solvent in which a sum of a polar term $\delta_P$ and a hydrogen-bonding term $\delta_H$ in Hansen solubility parameters is less than 8.0 $(J/cm^3)^{0.5}$.

**3.** The pattern forming method according to claim 1,

wherein the chemical liquid including two or more kinds of organic solvents includes an organic solvent A and an organic solvent B,

a boiling point of the organic solvent A is higher than a boiling point of the organic solvent B, and a sum of a polar term $\delta_P$ and a hydrogen-bonding term $\delta_H$ in Hansen solubility parameters of the organic solvent A is smaller than a sum of a polar term $\delta_P$ and a hydrogen-bonding term $\delta_H$ in Hansen solubility parameters of the organic solvent B.

**4.** The pattern forming method according to claim 1, wherein the metal compound includes at least one selected from the group consisting of a compound represented by Formula (1), a compound represented by Formula (2), and a condensate of the compound represented by Formula (2),

$$(R^1)_{n1}\text{-M-}(R^2)_{m1} \qquad (1)$$

in Formula (1), M represents a metal atom; $R^1$ represents an alkyl group which may have a substituent, an aliphatic unsaturated hydrocarbon group which may have a substituent, or an aryl group which may have a substituent; $R^2$ represents $-OCOR^{r1}$ or $-OR^{r2}$ where $R^{r1}$ represents a hydrogen atom, an alkyl group which may have a substituent, an aliphatic unsaturated hydrocarbon group which may have a substituent, or an aryl group which may have a substituent and $R^{r2}$ represents an alkyl group which may have a substituent, an aliphatic unsaturated hydrocarbon group which may have a substituent, or an aryl group which may have a substituent; and n1 + m1 represents a valence of the metal atom,

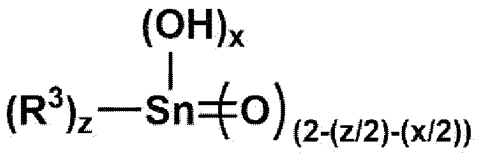
(2)

$$0 < z \leqq 2 \qquad (2\text{-}1)$$

$$0 < z+x \leqq 4 \qquad (2\text{-}2)$$

in Formula (2), $R^3$ represents a hydrocarbon group which may have a substituent; and z and x represent numbers satisfying a relationship of Expression (2-1) and a relationship of Expression (2-2).

**5.** The pattern forming method according to claim 1, wherein a content of the metal compound is 50% by mass or more with respect to a total solid content of the composition.

**6.** A method for manufacturing an electronic device, the method comprising the pattern forming method according to any one of claims 1 to 5.

## INTERNATIONAL SEARCH REPORT

International application No.
**PCT/JP2023/021998**

**A. CLASSIFICATION OF SUBJECT MATTER**

***G03F 7/32***(2006.01)i; ***G03F 7/004***(2006.01)i; ***G03F 7/20***(2006.01)i; ***H01L 21/027***(2006.01)i
FI: G03F7/32; G03F7/004; H01L21/30 569E; H01L21/30 569F; G03F7/32 501; G03F7/004 531; G03F7/20 521

According to International Patent Classification (IPC) or to both national classification and IPC

**B. FIELDS SEARCHED**

Minimum documentation searched (classification system followed by classification symbols)

G03F7/32; G03F7/004; G03F7/20; H01L21/027

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | WO 2017/164018 A1 (FUJIFILM CORPORATION) 28 September 2017 (2017-09-28) paragraphs [0089], [0102], examples 1-8 | 1-6 |
| A | JP 2020-021071 A (SAMSUNG SDI CO., LTD.) 06 February 2020 (2020-02-06) examples | 1-6 |
| A | JP 2019-144542 A (SHINETSU CHEMICAL CO) 29 August 2019 (2019-08-29) examples | 1-6 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **14 July 2023** | **01 August 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/021998**

| Patent document cited in search report | Publication date (day/month/year) | Patent family member(s) | Publication date (day/month/year) |
|---|---|---|---|
| WO 2017/164018 A1 | 28 September 2017 | US 2019/0018317 A1<br>paragraphs [0263]-[0266], examples 1-8<br>EP 3435159 A1<br>KR 10-2018-0113215 A<br>TW 201734640 A | |
| JP 2020-021071 A | 06 February 2020 | US 2020/0041897 A1<br>examples<br>KR 10-2020-0014216 A<br>CN 110780536 A<br>TW 202007691 A | |
| JP 2019-144542 A | 29 August 2019 | US 2019/0258160 A1<br>examples<br>KR 10-2019-0101296 A<br>TW 201937282 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20200326627 A
- JP 2014059543 A
- JP 2013061648 A
- WO 2017002737 A
- JP 2009267112 A
- WO 2018020878 A
- WO 2018030006 A
- JP 2021047426 A
- JP 2021179606 A
- JP 6805244 B
- WO 2019111727 A
- WO 2018193954 A


### Non-patent literature cited in the description


- *Proceedings of International Society for Optics and Photonics (Proc. of SPIE)*, 2008, vol. 6924, 692420
- Etching. Semiconductor Process Textbook. SEMI, 2007
- **HANSEN**. Solubility Parameters: A Users Handbook. CRC Press, 2007, 1-310
- **EYCHENNE-BARON et al.** *Organometallics*, 2000, vol. 19, 1940-1949